Europäisches Patentamt

**European Patent Office**

**Office européen des brevets**

(19)

(11) Numéro de publication: **0 086 739**
**B1**

(12) **FASCICULE DE BREVET EUROPEEN**

(45) Date de publication du fascicule du brevet:
**31.07.85**

(21) Numéro de dépôt: **83810036.0**

(22) Date de dépôt: **28.01.83**

(51) Int. Cl.⁴: **H 03 H 9/205,** H 03 H 9/19,
G 04 F 5/06

(54) **Résonateur piézoélectrique encastrable.**

(30) Priorité: **16.02.82 FR 8202497**

(43) Date de publication de la demande:
**24.08.83 Bulletin 83/34**

(45) Mention de la délivrance du brevet:
**31.07.85 Bulletin 85/31**

(84) Etats contractants désignés:
**CH DE GB IT LI NL**

(56) Documents cités:
**CH - A - 623 690**
**FR - A - 2 435 855**
**GB - A - 540 024**
**US - A - 3 015 789**
**US - A - 4 137 511**

(73) Titulaire: **CENTRE ELECTRONIQUE HORLOGER S.A.,**
**Maladière 71, CH-2000 Neuchâtel 7 (CH)**

(72) Inventeur: **Hermann, Jean, Evole 64, CH-2000 Neuchâtel**
**(CH)**
Inventeur: **Bourgeois, Claude, Sentier Ministre 4,**
**CH-2014 Bôle (CH)**

(74) Mandataire: **Bruillard, Joel, c/o Centre Electronique**
**Horloger S.A. Maladière 71, CH-2000 Neuchâtel 7 (CH)**

## Description

La présente invention concerne un résonateur piézoélectrique encastrable réalisé dans un substrat de quartz de coupe ZT et comportant deux plaques minces rectangulaires reliées entre elles par au moins un bras.

Un résonateur piézoélectrique de coupe ZT, auquel s'applique la présente invention, a été décrit dans le brevet suisse No 623 690 de la demanderesse. Il est réalisé dans une plaque mince rectangulaire de quartz dont la longueur est dirigée selon un axe X', la largeur est dirigée selon un axe Y' et l'épaisseur selon un axe Z'. L'axe Z' est situé dans le plan des axes électrique X et optique Z du cristal et forme avec l'axe Z un angle $\Phi$ tel que $16° < \Phi < 36°$ et l'axe Y' forme avec l'axe mécanique Y du cristal un angle $\theta$, tel que $10° < \theta < 30°$. Un tel résonateur vibre selon un mode de contour et est caractérisé par d'excellentes propriétés thermiques. En particulier, le coefficient thermique du premier ordre est nul et ne dépend pas de manière critique du rapport dimensionnel w/l de la plaque et les coefficients thermiques d'ordre plus élevés sont très faibles. Jusqu'à présent un tel résonateur devait être maintenu par des fils de suspension fixés en des points neutres. Un tel montage s'avère délicat et entraîne, outre un prix de revient élevé, une résistance aux chocs limitée.

Il existe sur le marché des quartz de coupes différentes parmi lesquelles la coupe GT est celle qui offre les propriétés thermiques les plus favorables. Le résonateur de coupe GT se présente sous la forme d'une plaque mince rectangulaire et vibre selon un mode de contour. Un résonateur de ce type, réalisé de manière à permettre son encastrement, a été présenté au 34th Annual Frequency Control Symposium, USA ERADCOM, Ft. Monmouth, NJ 07703 en mai 1980 sous le titre: »New frequency temperature characteristics of miniaturized GT-cut quartz resonators«. Le résonateur décrit est une plaque mince rectangulaire sur les côtés de laquelle des éléments de support ont été réalisés. Ces éléments de support sont complexes et ajoutent encore à la criticité intrinsèque des propiétés thermiques du quartz GT. Ses propriétés thermiques, en effet, dépendent de façon critique du rapport dimensionnel de la plaque et aussi des dimensions des éléments de support. Comme ces dimensions sont très faibles (typiquement 80 µm pour la largeur des éléments de support), les tolérances de fabrication impliquent nécessairement un ajustement individuel des propriétés thermiques de chaque résonateur, ce qui en accroît le prix de revient.

Aussi un objet de la présente invention est un résonateur ayant de bonnes propriétés thermiques dans un large domaine de température et offrant une grande résistance aux chocs.

Un autre objet de l'invention est un résonateur pouvant être fabriqué en série et ne nécessitant pas d'ajustement de ses propriétés thermiques.

Un autre objet de l'invention est un résonateur qui peut être réalisé à l'aide de procédés photolithographiques.

Un autre objet de l'invention est un résonateur facile à monter dans un boîtier.

Selon une caractéristique de l'invention, le résonateur comporte deux plaques rectangulaires reliées entre elles par au moins un bras résonnant lui-même relié à une zone d'encastrement.

D'autres objets, caractéristiques et avantages de la présente invention apparaîtront au cours de la description suivante d'exemples de réalisation particuliers, ladite description étant faite à titre d'exemple non-limitatif et en relation avec les dessins joints dans lesquels:

— la figure 1 montre le plan de coupe d'un résonateur ZT;
— la figure 2 montre une première variante de l'invention;
— les figures 3.a et 3.b montrent une autre géométrie des électrodes de la variante de la figure 2;
— les figures 4 et 5 montrent deux autres variantes de l'invention;
— la figure 6 montre un exemple de résonateur monté dans un boîtier;
— les figures 7 et 8.a montrent deux autres variantes de l'invention; et
— la figure 8.b montre une vue en coupe du bras résonnant de la figure 8.a.

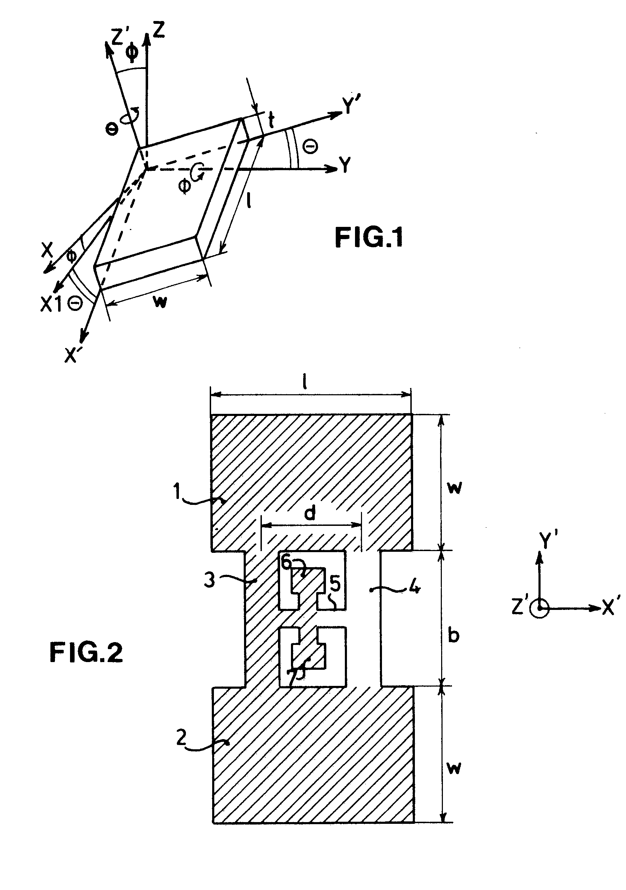

La figure 1 montre un résonateur de coupe ZT, tel que décrit dans le brevet précité. La plaque de coupe ZT s'obtient à partir d'un substrat de coupe Z, c'est-à-dire une plaque perpendiculaire à l'axe optique Z du cristal de quartz. Une première rotation d'angle $\Phi$ autour de l'axe mécanique Y amène l'axe optique Z en Z' et l'axe électrique X en X1. Une seconde rotation d'angle $\theta$ autour de l'axe Z' amène les axes X1 et Y en X' et Y' respectivement. Les directions X', Y' et Z' correspondent respectivement à la longueur l, la largeur w et l'épaisseur t de la plaque de coupe ZT. Selon les normes IRE, une telle coupe est notée: (Z X w t) $\Phi$, $\theta$. Les angles $\Phi$ et $\theta$ sont tels que $\Phi$ est compris entre 16° et 36° et $\theta$ est compris entre 10° et 30° et le rapport dimensionnel w/l est compris entre 0,5 et 0,8. Toutefois les meilleurs résultats ont été obtenus avec un résonateur dont les valeurs de $\Phi$, $\theta$ et w/l sont 26°, 20° et environ 2/3 respectivement.

La figure 2 montre une première variante de résonateur en accord avec les principes de la présente invention. Le résonateur comporte deux plaques 1 et 2 reliées par deux bras résonnants 3 et 4. Les bras sont dits résonnants car ils vibrent de manière telle que les contraintes à la liaison entre les bras et les plaques soient négligeables. Une barre de liaison 5 relie les bras résonnants aux zones d'encastrement 6 et 7. Les dimensions du résonateur répondent aux critères suivants. La largeur w de chaque plaque détermine la fréquence, la constante de fré-

quence étant approximativement 2823 kHz mm. Le rapport de la largeur à la longueur, soit w/l, contrôle le coefficient thermique de second ordre de la caractéristique de fréquence; il doit être compris entre 0,5 et 0,9, l'optimum étant atteint lorsque w/l est approximativement égal à 0,7. La longueur b des bras résonnants 3 et 4 doit être ajustée de manière à annuler les contraintes sur la ligne de séparation entre bras et plaque; elle doit être supérieure à la largeur w de telle sorte que le rapport b/w soit compris entre 1 et 1,1. Cependant, si de légères contraintes sont tolérées sur ladite ligne de séparation, le rapport b/w peut alors être compris entre 0,7 et 1,4. La distance d entre les centres des bras résonnants 3 et 4 doit être choisie de manière à annuler l'effet d'une variation de la longueur b des bras résonnants sur le coefficient thermique de premier ordre de la caractéristique de fréquence; elle doit être telle que le rapport de cette distance à la longueur de chaque plaque, soit d/l, soit compris entre 0,3 et 0,7, l'optimum étant atteint lorsque d/l est approximativement égal à 0,5. La largeur de la barre de liaison 5 n'est pas critique; elle ne doit cependant ni être trop petite pour assurer une bonne résistance aux chocs du résonateur, ni être trop grande pour ne pas trop influer sur la fréquence de résonance des bras 3 et 4. En pratique, la largeur de la barre de liaison sera inférieure à sa longueur. L'épaisseur t du résonateur est, en principe, un paramètre libre comme dans tous les résonateurs à modes de contour; elle doit, toutefois, être choisie de manière à éviter tout couplage avec les modes de vibration hors du plan et peut être comprise entre 25 et 250 μm, une épaisseur de 150 μm étant un bon compris.

La figure 2 montre encore un exemple de disposition des électrodes, l'électrode supérieure étant représentée par des hachures et l'électrode inférieure (non représentée) étant disposée de manière symétrique à la première par rapport au centre du résonateur.

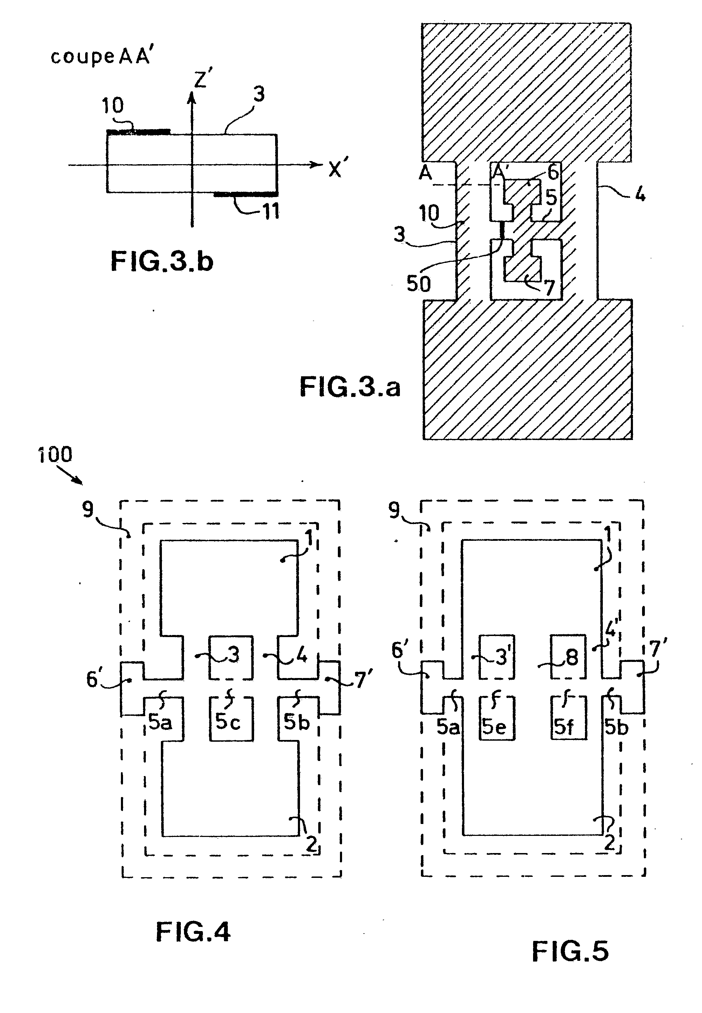

Les figures 3.a et 3.b montrent encore une autre disposition possible d'électrodes. Comme l'indiquent les figures, les électrodes supérieure 10 et inférieure 11 sont symétriques l'une de l'autre par rapport au centre du resonateur. Une telle disposition des électrodes permet de supprimer le couplage du mode de vibration fondamental en allongement selon l'axe Y'. La figure 3.a montre encore une autre différence par rapport au résonateur de la figure 2. En effet, selon la figure 3.a, seul le bras résonnant 4 est relié aux zones d'encastrement 6 et 7 par la barre de liaison 5, la coupure 50 libérant le bras résonnant 3. Il est également possible, avec les résonateurs des figures 2 et 3.a, de ne prévoir qu'une seule zone d'encastrement 6 ou 7.

Le fonctionnement d'un résonateur, tel que décrit ci-dessus, est le suivant. Le mode de vibration utilisé est un mode d'allongement selon la direction Y'. Chaque plaque 1 ou 2, vibre comme le résonateur rectangulaire de coupe ZT décrit dans le brevet précité, les mouvements des deux plaques étant en phase. Les bras 3 et 4 sont également en résonance mais ils vibrent (allongement selon Y') en opposition de phase avec les plaques 1 et 2; leur longueur est choisie de manière à perturber le moins possible le mouvement idéal des plaques, afin que celles-ci puissent être considérées comme des résonateurs, quasi libres, la barre de liaison 5 est le siège d'une oscillation forcée dont l'amplitude diminue d'une manière très marquée lorsqu'on s'éloigne des régions de contact avec les bras, pour être négligeable au niveau des zones d'encastrement 6 et 7.

Les figures 4 et 5 montrent des variantes du résonateur de l'invention, selon lesquelles les zones d'encastrement sont disposées à la l'extérieur du résonateur. Dans les deux figures, les éléments analogues à ceux de la figure 2 portent les mêmes références. Le résonateur de la figure 4 est identique à celui de la figure 2 à l'exception de la position des zones d'encastrement 6' et 7' et de la barre de liaison qui est constituée de trois parties 5a, 5b et 5c qui relient respectivement la zone d'encastrement 6' au bras résonnant 3, le bras résonnant 4 à la zone d'encastrement 7' et les deux bras résonnants 3 et 4 entre eux. Les zones d'encastrement peuvent être constituées par un cadre 9 (représenté en pointillé) entourant le résonateur proprement dit et facilitant son encapsulation, ainsi qu'il sera vu plus loin. La partie 5c de la barre de liaison n'est pas indispensable et peut être supprimé. Le résonateur de la figure 5 présente trois bras résonnants dont les deux extrêmes 3' et 4' ont une largeur environ deux fois plus faible que celle du bras central 8. Les zones d'encastrement 6' et 7' peuvent également être constituées par un cadre 9. La barre de liaison est constituée de quatre parties 5a, 5b, 5e et 5f, les deux parties centrales 5 et 5f pouvant être supprimées.

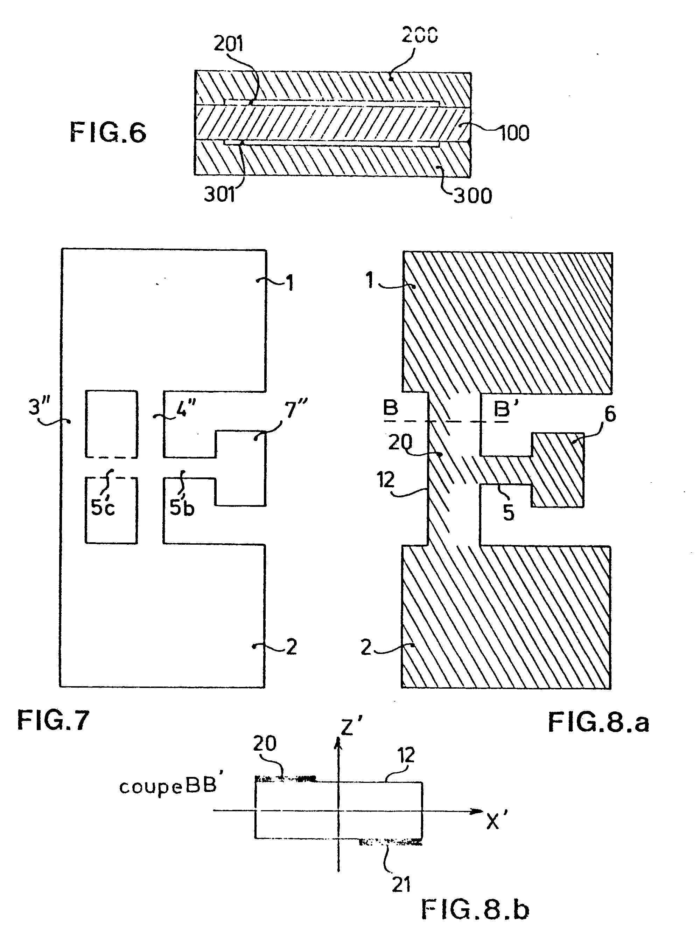

La figure 6 montre un exemple d'encapsulation de résonateurs dont les zones d'encastrement sont extérieures. Le résonateur 100, identique au résonateur de la figure 4 ou de la figure 5, est monté entre deux plaques 200 et 300 qui présentent chacune un évidement 201 ou 301 au niveau de la partie active du résonateur. Les deux plaques 200 et 300 sont fixées, par exemple par collage, sur le cadre du résonateur constituant ainsi un boîtier. Ces plaques peuvent être réalisées dans un cristal de quartz de coupe ZT, dans un métal dont le coefficient de dilatation est voisin de celui du quartz ou dans tout autre matériau adéquat tel, par exemple, qu'en céramique. Dans le cas de plaques métalliques, celles-ci réalisent la liaison électrique entre le résonateur et le circuit oscillateur qui lui associé. Au contraire, dans le cas de plaques isolantes, celles-ci seront métallisées de manière appropriée et la liaison entre plaques et résonateur pourra être réalisée à l'aide d'une colle conductrice.

Les figures 7 et 8 montrent deux variantes dissymétriques de résonateurs selon l'invention. Le résonateur de la figure 7 a deux bras résonnants 3'' et 4'' reliés à une seule zone d'encastrement 7″ par l'intermédiaire d'une barre de liaison en deux parties 5'b et 5'c, la partie 5'c pouvant être éventuellement supprimée. Le résonateur de la figure 8.a ne présente qu'un seul bras résonnant 12 relié a une zone d'encastrement 6 par une barre de liaison 5. La partie hachurée 20 montre l'électrode supérieure et la vue en coupe, selon l'axe BB', de la figure 8.b montre la disposition de l'électrode inférieure 21 dans la région du bras 12.

Le résonateur de l'invention peut être réalisé au moyen d'un usinage chimique. En effet, la normale à un substrat de quartz de coupe ZT fait un angle inférieur à 27° avec l'axe optique Z du cristal qui constitue la direction d'attaque privilégiée du substrat. Ainsi, sur un même substrat, plusieurs résonateurs peuvent être découpés simultanément, permettant une fabrication en série. Le coût de fabrication est encore réduit grâce au fait qu'aucun ajustement des propriétés thermiques n'est requis et que le montage d'un résonateur selon l'invention est aisé.

## Revendications

1. Résonateur piézoélectrique encastrable réalisé dans un substrat de quartz de coupe ZT et comportant deux plaques minces rectangulaires (1, 2) reliées entre elles par au moins un bras, caractérisé en ce que ledit bras (3, 4) est résonnant et est relié à au moins une zone d'encastrement (6, 7).

2. Résonateur selon la revendication 1, caractérisé en ce que les deux plaques rectangulaires (1, 2) sont reliées entre elles par deux bras résonnants (3, 4) et en ce que lesdits bras résonnants sont reliés à deux zones d'encastrement (6, 7) par une barre de liaison (5).

3. Résonateur selon la revendication 1, caractérisé en ce que les deux plaques rectangulaires (1, 2) sont reliées entre elles par deux bras résonnants (3, 4) et en ce qu'un bras résonnant (4) est relié à une zone d'encastrement (6).

4. Résonateur selon la revendication 2 ou la revendication 3, caractérisé en ce que lesdites zones d'encastrement (6, 7) sont disposées entre lesdits bras résonnants (3, 4).

5. Résonateur selon la revendication 2, caractérisé en ce que lesdites zones d'encastrement (6, 7) sont disposées à l'extérieur du résonateur.

6. Résonateur selon la revendication 1, caractérisé en ce que les deux plaques rectangulaires sont reliées entre elles par trois bras résonnants (3', 4', 8), les deux bras extérieurs (3', 4') étant reliés, chacun, à une zone d'encastrement (6', 7') par une barre de liaison (5a, 5b).

7. Résonateur selon la revendication 5 ou la revendication 6, caractérisé en ce que lesdites zones d'encastrement sont constituées par un cadre (9) entourant ledit résonateur.

8. Résonateur selon l'une quelconque des revendications 1 à 7, caractérisé en ce que le rapport b/w de la longueur du ou des bras résonnants à la largeur desdites plaques rectangulaires est compris entre 0,7 et 1,4.

9. Résonateur selon l'une quelconque des revendications 1 à 7, caractérisé en ce que le rapport b/w de la longueur du ou des bras résonnants à la largeur desdites plaques rectangulaires est compris entre 1 et 1,1.

## Patentansprüche

1. Einspannbarer piezoelektrischer Resonator, hergestellt in einem Quarzsubstrat mit ZT-Schnitt und umfassend zwei dünne rechteckige Platten (1, 2), die miteinander über mindestens einen Arm verbunden sind, dadurch gekennzeichnet, daß der genannte Arm (3, 4) resonanzerzeugend ist und mit mindestens einer Einspannzone (6, 7) verbunden ist.

2. Resonator nach Anspruch 1, dadurch gekennzeichnet, daß die beiden rechteckigen Platten (1, 2) miteinander über zwei resonanzerzeugende Arme (3, 4) verbunden sind und daß die genannten resonanzerzeugenden Arme mit zwei Einspannzonen (6, 7) über eine Verbindungsleiste (5) verbunen sind.

3. Resonator nach Anspruch 1, dadurch gekennzeichnet, daß die beiden rechteckigen Platten (1, 2) miteinander über zwei resonanzerzeugende Arme (3, 4) verbunden sind und daß nur ein resonanzerzeugender Arm (4) mit einer Einspannzone (6) verbunden ist.

4. Resonator nach Anspruch 2 oder 3, dadurch gekennzeichnet, daß die genannten Einspannzonen (6, 7) zwischen den resonanzerzeugenden Armen (3, 4) angeordnet sind.

5. Resonator nach Anspruch 2, dadurch gekennzeichnet, daß die genannten Einspannzonen (6, 7) außerhalb des Resonators angeordnet sind.

6. Resonator nach Anspruch 1, dadurch gekennzeichnet, daß die beiden rechteckigen Platten über drei resonanzerzeugende Arme (3', 4', 8) verbunden sind, wobei die beiden äußeren Arme (3', 4') jeweils mit einer Einspannzone (6', 7') über eine Verbindungsleiste (5a, 5b) verbunden sind.

7. Resonator nach Anspruch 5 oder 6, dadurch gekennzeichnet, daß die genannten Einspannzonen von einem den genannten Resonator umgebenden Rahmen (9) gebildet sind.

8. Resonator nach einem der Ansprüche 1 bis 7, dadurch gekennzeichnet, daß das Verhältnis b/w der Länge des oder der resonanzerzeugenden Arme zur Breite der genannten rechteckigen Platten zwischen 0,7 und 1,4 liegt.

9. Resonator nach einem der Ansprüche 1 bis 7, dadurch gekennzeichnet, daß das Verhältnis b/w der Länge des oder der resonanzerzeugenden Arme zur Breite der genannten rechteckigen Platten zwischen 1 und 1,1 liegt.

## Claims

1. A clamped piezo-electric resonator fabricated in a ZT-cut quartz substrate, comprising two thin rectangular plates (1, 2) connected together by at least one arm, characterized in that said at least one arm (3, 4) is resonant and is connected to at least one support zone (6, 7).

2. Resonator according to claim 1, characterized in that the two rectangular plates (1, 2) are connected together by two resonant arms (3, 4) and in that the said resonant arms are connected to two support zones (6, 7) by a linking bar (5).

3. Resonator according to claim 1, characterized in that the two rectangular plates (1, 2) are connected together by two resonant arms (3, 4) and in that one resonant arm (4) is connected to one support zone (6).

4. Resonator according to claim 2 or claim 3, characterized in that the said support zones (6, 7) are arranged between the said resonant arms (3, 4).

5. Resonator according to claim 2, characterized in that the said support zones (6, 7) are arranged outside the resonator.

6. Resonator according to claim 1, characterized in that the two rectangular plates are connected together by three resonant arms (3', 4', 8), the two outside arms (3', 4'), being each connected to a support zone (6', 7') by a linking bar (5a, 5b).

7. Resonator according to claim 5 or claim 6, characterized in that the said support zones form part of a frame (9) surrounding the said resonator.

8. Resonator according to any one of the claims 1 to 7, characterized in that the ratio b/w of the length of the resonant arm or arms to the width of the said rectangular plates lies between 0.7 and 1.4.

9. Resonator according to any one of the claims 1 to 7, characterized in that the ratio b/w of the length of the resonant arm or arms to the width of the said rectangular plates lies between 1 and 1.1.

FIG.1

FIG.2

coupe A A'

## FIG.3.b

## FIG.3.a

## FIG.4

## FIG.5

## FIG.6

## FIG.7

## FIG.8.a

coupe BB'

## FIG.8.b